# EUROPÄISCHE PATENTSCHRIFT

(11) **EP 3 139 711 B1**
(45) Veröffentlichungstag und Bekanntmachung des Hinweises auf die Patenterteilung: **06.05.2020**
(21) Anmeldenummer: 15183748.1
(22) Anmeldetag: 03.09.2015
(51) Int. Cl.: H05K 1/02

(54) **ELEKTRONIKVORRICHTUNG UND RÜCKBLICKVORRICHTUNG**
ELECTRONICS DEVICE AND REAR VIEW DEVICE
DISPOSITIF ELECTRONIQUE ET DISPOSITIF DE RETROVISEUR

(43) Veröffentlichungstag der Anmeldung: 08.03.2017
(73) Patentinhaber: SMR Patents S.à.r.l., 2453 Luxembourg (LU)
(72) Erfinder: Herrmann, Andreas, 71364 Winnenden-Baach (DE); Rudi, Artem, 71634 Ludwigsburg (DE)
(74) Vertreter: Weber-Bruls, Dorothée

(56) Entgegenhaltungen:
- EP-A2- 1 205 350
- EP-A2- 1 623 885
- DE-A1-102007 037 483
- DE-B3-102012 108 480

## Beschreibung

Die Erfindung betrifft eine Elektronikvorrichtung, die für die Verwendung in einer Rückblickvorrichtung eines Kraftfahrzeuges eingerichtet ist, und eine Rückblickvorrichtung mit einer derartigen Elektronikvorrichtung.

Elektronikvorrichtungen sind bei Rückblickvorrichtungen, beispielsweise bei Außenspiegeln, von Kraftfahrzeugen bekannt. Diese umfassen jeweils ein Elektronikmodul, welches in einer Gehäuseeinrichtung angeordnet und in der Rückblickvorrichtung, beispielsweise dem Außenspiegel, festgelegt ist. Aufgrund der Vielzahl an elektrischen Verbrauchern, wie Wiederholblinkleuchte, Totwinkelanzeige, Annäherungslicht oder sogenannten Logolampen, ist jedem elektrischen Verbraucher ein eigenes Elektronikmodul mit eigener Gehäuseeinrichtung zugeordnet. Die Elektronikmodule bestehen jeweils aus einer Leitereinheit, die als separate Bauteile in der jeweiligen Gehäuseeinrichtung festgelegt sind.

Aufgrund der Vielzahl von elektrischen Verbrauchern und der entsprechend hohen Anzahl an den elektrischen Verbrauchern funktional zugeordneten Elektronikmodulen, ist bei den bekannten Rückblickvorrichtungen ein entsprechend hoher Platzbedarf zum Anordnen der Vielzahl von Elektronikvorrichtungen vorzuhalten. Darüber hinaus erweist sich die Montage der einzelnen Elektronikmodule als zeitaufwändig und wartungsunfreundlich.

Aus der EP 1 205 350 A2 ist ein Lenkstockschalter, insbesondere für Kraftfahrzeuge, mit einem Grundgehäuse mit Boden und Seitenwänden, mit einem Gehäusedeckel, mit mehreren Schaltereinheiten und mit die Schaltereinheiten kontaktierenden Leiterbahnen bekannt. Dabei sind die Leiterbahnen als ein ein- oder mehrteiliges Kontaktgitter ausgebildet. Zudem erstreckt sich das Kontaktgitter über Abschnitte wenigstens einer Seitenwand und des Bodens des Grundgehäuses.

Eine kompakte multifunktionale elektronische Baugruppe mit einem Schaltungsträger ist in der DE 10 2007 037 483 A1 beschrieben. Dabei sind auf der Außenoberfläche des Schaltungsträgers eine Mehrzahl von elektronischen Bauelementen, insbesondere Schaltelementen, angeordnet. Die Verbindung der Bauelemente untereinander und mit einer Kontakteinrichtung erfolgt über Leiterbahnen und Kontaktflächen, die mehrdimensional verlaufend auf Oberflächenbereichen des Schaltungsträgers angeordnet sind. Der Schaltungsträger ist als Spritzgussteil.

Die EP 1 623 885 A2 offenbart ein Airbagmodul zur Verwendung in einer Fahrzeuginsassen-Rückhalteeinrichtung mit einem aus Kunststoff gebildeten Generatorträger, auf dem Generatorträger eine durch Abscheiden von Metall gebildete gedruckte Schaltung vorgesehen ist, wobei die gedruckte Schaltung zur Auslösung eines elektrischen Funktionselements mit einem auf einem Abschnitt des Generatorträgers angeordneten Schaltelement zusammenwirkt.

Aus der DE 10 2012 108 480 B3 ist ein Kopfteil für eine Rückblickvorrichtung bekannt, bei dem eine Elektronikeinheit in einem Hohlraum zwischen einem Gehäuseteil und einem Deckelteil gehalten ist. Das Gehäuseteil und das Deckelteil dichten den Hohlraum ab, sodass es keines gesonderten Gehäuses für die Elektronikeinheit bedarf. Die Elektronikeinheit ist in einer Aufnahme gehalten, welche als eine Art Arm ausgebildet ist, der sich am Gehäuseteil abstützt und von diesem in den Hohlraum hineinragt. In der Aufnahme ist insbesondere eine Platine gehalten, auf der ein Leuchtmittel angeordnet ist, das einem Lichtfenster in dem Gehäuseteil gegenüberliegt, sodass das von dem Leuchtmittel ausgehende Licht durch das Gehäuseteil nach außen gelangt.

Die Aufgabe der Erfindung ist es, eine Elektronikvorrichtung, die für die Verwendung in einer Rückblickvorrichtung eines Kraftfahrzeuges eingerichtet ist, zu liefern, die kompakt aufgebaut ist und bei der Montagetätigkeiten erleichtert sind.

Diese Aufgabe wird durch die Elektronikvorrichtung von Anspruch 1 gelöst, die für die Verwendung in einer Rückblickvorrichtung für ein Kraftfahrzeug eingerichtet ist, mit mindestens einer Gehäuseeinrichtung, die mindestens ein Bodenteil und ein am Bodenteil anordbares oder angeordnetes Deckelteil umfasst, welche im gefügten Zustand einen zumindest nahezu in Gänze geschlossenen Hohlraum begrenzen, mit mindestens einem ersten Haltemittel einer Halteeinheit, durch die die Gehäuseeinrichtung in oder an der Rückblickvorrichtung festlegbar oder festgelegt ist, und mit mindestens einem Elektronikmodul, das mindestens eine Leitereinheit und mindestens ein mit der Leitereinheit verbundenes Kontaktmittel umfasst, wobei auf einer dem Hohlraum zugewandten Oberfläche des Bodenteils und/oder Deckelteils die Leitereinheit angeordnet ist, welche mindestens einen Träger und mindestens eine unmittelbar auf dem Träger aufgebrachte Leiterbahn umfasst, das sich durch das Deckelteil und/oder durch das Bodenteil erstreckende Kontaktmittel mit mindestens einem hervorstehenden Kontaktabschnitt von außen zugänglich ist, durch eine an den Hohlraum angrenzende und dem Hohlraum zugewandte Funktionsfläche des Bodenteils und/oder des Deckelteils der mindestens eine Träger der mindestens einen Leitereinheit zumindest abschnittweise gebildet ist, und das Deckelteil und/oder Bodenteil mit dem mindestens einem erstes Haltemittel der Halteeinheit in einem gemeinsames Bauteil ausgebildet ist bzw. sind.

Bevorzugte erfindungsgemäße Elektronikvorrichtungen sind in den Ansprüchen 2 bis 14 beschrieben.

Dadurch, dass mindestens ein Träger einer Leitereinheit zumindest abschnittsweise durch eine Funktionsfläche des Bodenteils und/oder des Deckelteils gebildet ist, ist die Elektronikvorrichtung bauteilreduziert und kompakt ausbildbar. Weiter ist hierdurch ein Montageaufwand reduziert.

Neben den Leiterbahnen kann die Leitereinheit weitere elektronische Bauteile wie Integrierte Schaltkreise (IC), Kondensatoren, Widerstände oder dergleichen umfassen. Diese sind können ebenfalls an dem Träger, insbesondere an der Funktionsfläche des Bodenteils und/oder des Deckelteils angeordnet werden.

Die Leitereinheit kann platinenartig ausgebildet sein, ohne eine separates Bauteil zu umfassen. Solchenfalls kann die Leitereinheit in Gänze durch die Funktionsfläche gebildet sein. Es ist denkbar, dass Komponenten der Leitereinheit als separate Bauteile an die Funktionsfläche anfügbar sind, ohne dass die Leitereinheit in Gänze durch das separate Bauteil gebildet ist.

Bei einer Weiterbildung des genannten Ausführungsbeispiels erweist es sich als vorteilhaft, wenn mindestens ein Träger des mindestens einen Trägers in Gänze durch die Funktionsfläche des Bodenteils und/oder Deckteilteils gebildet ist. Solchenfalls kann auf einen als separates Bauteil ausgebildeten Träger des Elektronikmoduls in Gänze verzichtet werden, wenn die Funktionsfläche des Bodenteils bzw. des Deckelteils des zuvor als separates Bauteil ausgebildeten Träger übernimmt.

Die auf dem Träger, insbesondere auf die Funktionsfläche, aufgebrachte Leiterbahn kann grundsätzlich nach den für als separate Bauteile ausgebildeten Leitereinheiten entsprechend realisiert werden. Die Elektronikvorrichtung lässt sich jedoch kompakt ausgestalten, wenn die unmittelbar auf dem Träger, insbesondere der Funktionsfläche, aufgebrachte Leiterbahn mittels Spritzguss (Molded Interconnect Devices [MID]), durch eine leitende Folie (Inmold-Labeling [IML]) und/oder durch Laser-Direkt-Strukturierung [LDS] unmittelbar an den Träger, insbesondere die Funktionsfläche, aufgebracht ist.

Darüber hinaus lässt sich die Anzahl an Gehäuseeinrichtungen und darin angeordneten Elektronikmodulen reduzieren, wenn das Elektronikmodul einen Mehrzahl an Leitereinheiten umfasst und/oder wenn das Elektronikmodul eine gemeinsame Steuereinheit für eine Mehrzahl an elektrischen Verbrauchern der Rückblickvorrichtung bildet, wobei jedem elektrischen Verbraucher mindestens eine Leitereinheit funktional zuordenbar oder zugeordnet ist und wobei insbesondere mindestens eine Hauptleitereinheit eine Treiberschaltung umfasst durch die die den elektrischen Verbrauchern funktional zugeordneten Leitereinheiten einzeln und/oder gemeinsam ansteuerbar sind.

Hierdurch ist es ermöglicht, die bisher als separate und voneinander unabhängig betriebenen Elektronikmodule in einem gemeinsamen Elektronikmodul zu vereinen. Hierdurch ist auch die Zahl der vorzuhaltenden Gehäuseeinrichtungen auf eine einzige Gehäuseeinrichtung reduzierbar, in der das gemeinsame Elektronikmodul angeordnet ist. Hierdurch lässt sich die Rückblickvorrichtung bauteilreduziert und kompakt ausbilden, da ein geringerer Platzbedarf zum Unterbringen der Elektronikvorrichtung vorgehalten werden muss.

Darüber hinaus erweist es sich als vorteilhaft, dass die mindestens eine Halteeinheit mindestens ein erstes Haltemittel umfasst, das mit dem Deckelteil und/oder dem Bodenteil ein gemeinsames Bauteil, insbesondere Spritzgussteil, umfasst.

Wenn das erste Haltemittel der Halteeinheit mit dem Deckelteil oder dem Bodenteil ein gemeinsames Bauteil, insbesondere Spritzgussteil, bildet, ist die Elektronikvorrichtung bauteilreduziert ausbildbar und die Montagefreundlichkeit weiter erhöht.

Ferner erweist es sich als vorteilhaft, wenn die Gehäuseeinrichtung durch die Halteeinheit, insbesondere durch das erste Haltemittel, lösbar, insbesondere mittels Hintergriff, in oder an der Rückblickvorrichtung festlegbar oder festgelegt ist und/oder wenn das erste Haltemittel einen Außengewindeabschnitt am Deckelteil oder am Bodenteil, ein Rastelement, wie Clips oder Bajonettverschluss, und/oder eine Schraub- oder Bolzenelement umfasst.

In Weiterbildung des genannten Ausführungsbeispiels erweist es sich als vorteilhaft, wenn die Halteeinheit ein in oder an der Rückblickvorrichtung, insbesondere an einer Halteplatte der Rückblickvorrichtung, festgelegtes, zweites Haltemittel umfasst, das einen Innengewindeabschnitt umfasst, der mit dem als Außengewindeabschnitt ausgebildeten ersten Haltemittel zusammenwirkbar ist, das ein mit dem als Rastelement ausgebildeten ersten Haltemittel hintergreifend zusammenwirkendes Aufnahmemittel und/oder das eine Aufnahme für das als Schraub- oder Bolzenelement ausgebildete erste Haltemittel umfasst.

Beim Fertigen der Elektronikvorrichtung werden einzelne Komponenten des Elektronikmoduls maschinell an der Funktionsfläche des Deckelteils und/oder des Bodenteils angeordnet. Das zur Montage der Komponenten des Elektronikmoduls verwendete Werkzeug verfährt hierbei parallel zu einer durch Vektoren x und y aufgespannten Ebene der Funktionsfläche des Deckelteils und/oder des Bodenteils, wobei es beim Fügen einzelner Komponenten quer zu dieser Ebene entlang eines Vektors z verfährt. Um die Bewegung in z-Richtung gering zu halten, erweist es sich als vorteilhaft, wenn das erste Haltemittel mit einem ersten Ende an einem der Funktionsfläche des Deckelteils oder des Bodenteils entgegengesetzten Ende des Deckelteils bzw. des Bodenteils festgelegt und mit einem zweiten Ende in Richtung Funktionsfläche erstreckt angeordnet ist, wobei das erste Haltemittel überlappungsfrei zur Ebene der Funktionsfläche erstreckt ausgebildet ist und das zweite Ende zur Ebene der Funktionsfläche einen Abstand aufweist.

Dieses erweist sich insbesondere als vorteilhaft, wenn das erste Haltemittel clipsartig ausgebildet ist. Solchenfalls sind die als Clipse ausgebildeten Haltemittel in z-Richtung erstreckt, ragen jedoch nicht über die Funktionsfläche hinaus. Hierdurch können weiten Montagewegen des zur Montage verwendeten Werkzeugs vorgebeugt werden, die bei über die Funktionsfläche hinausragenden Haltemitteln notwendig wären, um die Haltemittel nicht zu beschädigen.

Wenn das erste Haltemittel beispielsweise einen Aussengewindeabschnitt am Deckelteil oder am Bodenteil der Gehäuseeinrichtung umfasst und das zweite Haltemittel einen Innengewindeabschnitt umfasst, lässt sich die Elektronikvorrichtung ohne weiteres werkzeuglos in die Rückblickvorrichtung festlegend einschrauben.

Wenn das erste Haltemittel ein Rastelement umfasst und das zweite Haltemittel ein mit dem Rastmittel zusammenwirkendes Aufnahmemittel, kann die Elektronikvorrichtung durch einfaches Einclipsen der Elektronikvorrichtung in die Rückblickvorrichtung montiert werden. Darüber hinaus ist solchenfalls auch die Wartung der Elektronikvorrichtung erleichtert, da die Elektronikvorrichtung werkzeuglos zur Rückblickvorrichtung beigeschraubt oder durch Lösen der Clipsverbindung werkzeugfrei entfernt werden kann.

Die Elektronikvorrichtung lässt sich auf einfache Weise mit einer Stromquelle verbinden, wenn der mindestens eine hervorstehende und von außen zugängliche Kontaktabschnitt des mindestens einen Kontaktmittels mindestens einen Pin, insbesondere eine Mehrzahl an Pins, umfasst, durch die das Elektronikmodul mit mindestens einer Stromquelle und/oder mit mindestens einem elektrischen Verbraucher verbindbar oder verbunden ist.

Darüber hinaus hat es sich bei einem Ausführungsbeispiel der Elektronikvorrichtung als vorteilhaft erwiesen, wenn die Elektronikvorrichtung mindestens einen im Hohlraum der Gehäuseeinrichtung angeordneten und im Elektronikmodul funktional zugeordneten Energiespeicher umfasst, zum insbesondere Speichern und Freisetzen von elektrischer Energie.

Solchenfalls ist es beispielsweise ermöglicht eine von der Stromquelle autarke Energiereserve vorzuhalten, um beispielsweise Leistungsspitzen auszugleichen oder um im Falle eines Ausfalles der Stromquelle ein Energiereservoir bereitzuhalten, um beispielsweise Warnblickfunktionen zumindest zeitig begrenzt aufrechtzuerhalten.

Um ein Fügen des Deckelteils an das Bodenteil zu vereinfachen, insbesondere um die Gefahr eines Verkantens beim Fügen des Deckelteils an das Bodenteil zu reduzieren, erweist es sich als vorteilhaft, wenn das Deckelteil und das Bodenteil jeweils einen zylindrischen Abschnitt umfassen, mit dem sie beim Fügen, insbesondere konzentrisch, teleskopartig ineinander schiebbar sind, wobei das Deckelteil einen radial bezüglich des zylindrischen Abschnitts hervorstehenden und um die Außenfläche des Deckteils vollständig umlaufenden Randabschnitt umfasst, der beim Fügen des Deckelteils und des Bodenteils einen Endanschlag bildet.

Durch die runde Form wird zudem eine gleichmäßige Verteilung der Spannkraft der Halteeinheit erzielt und durch das Bereitstellen einer gleichmäßigen runden Auflagefläche eine gute Dichtfläche zur Verfügung gestellt.

In Weiterbildung letztgenannter Ausführungsform erweist es sich insbesondere als vorteilhaft, wenn das Deckelteil und/oder das Bodenteil topfartig aus ausgebildet ist/sind, wobei zumindest das Deckelteil eine an den zylindrischen Abschnitt angrenzende flächenhafte Bodenplatte umfasst, die quer oder schräg zur Achse des zylindrischen Abschnitts verläuft und an deren dem Bodenteil zugewandten Seite die Funktionsfläche angeordnet ist sowie an deren dem Bodenteil abgewandten und durch den zylindrischen Abschnitt umgebenen Seite der Kontaktabschnitt des Kontaktmittels angeordnet ist.

Durch das Ausbilden des Bodenteils und des Deckelteils mit jeweils einem zylindrischen Abschnitt, die beim Fügen konzentrisch und teleskopartig ineinander verschiebbar sind, wird eine gleichmäßige Auflagefläche zur Verfügung gestellt. Hierdurch kann eine zwischen dem Bodenteil und dem Deckelteil bestehender Spalt gering gehalten werden. Ferner erweist es sich insbesondere als vorteilhaft, wenn die Elektronikvorrichtung mindestens ein zwischen dem Deckelteil und dem Bodenteil, insbesondere zwischen dem Bodenteil und dem Randabschnitt des Deckelteils, angeordnetes Dichtmittel umfasst, durch das der Hohlraum der Gehäuseeinrichtung gegenüber einem zwischen Deckelteil und Bodenteil bestehenden Spalt abdichtbar ist.

Hierdurch wird einem Eindringen von Feuchtigkeit und Schmutz in den Hohlraum vorgebeugt, wodurch die Gefahr eines Verschmutzens, insbesondere eines Beschädigens, des Elektronikmoduls reduziert ist.

Die Elektronikvorrichtung lässt sich besonders einfach montieren und zu Wartungszwecken wieder demontieren, wenn das Bodenteil der Gehäuseeinrichtung ein einstückiges Element eines

Bauteils, insbesondere eines einstückigen Spritzgussteils, wie Halteplatte, der Rückblickvorrichtung umfasst. Solchenfalls sind die einzelnen Komponenten der Elektronikvorrichtung derart vormontierbar, dass zur Endmontage lediglich das Deckelteil, an dem das Elektronikmodul, das erste Haltemittel der Halteeinheit sowie das Dichtmittel festgelegt sind lediglich auf das Bodenteil aufgeschraubt oder aufgeklebt werden. Hierdurch lassen sich die vormals Mehrzahl an einzelnen Elektronikmodulen mit vormals einer Mehrzahl an Gehäuseeinrichtungen, die jeweils aus einer Vielzahl an separaten Bauteilen gebildet waren, durch einen einzigen Handgriff montieren oder demontieren.

Schließlich lässt sich die Elektronikvorrichtung gewichtsreduziert und kostengünstig herstellen, wenn das Bodenteil, das Deckelteil, das erste Haltemittel und/oder das zweite Haltemittel einen Kunststoff umfassen.

Schließlich wird die Aufgabe der Erfindung gelöst durch eine Rückblickvorrichtung mit mindestens einer erfindungsgemäßen Elektronikvorrichtung.

Die Elektronikvorrichtung und die Rückblickvorrichtung erweisen sich in mehrfacher Hinsicht als vorteilhaft:

Dadurch, dass ein Bodenteil und/oder das Deckelteil eine hohlraumzugewandte Funktionsfläche umfassen, die zumindest abschnittsweise den Träger der Leitereinheit bildet, ist die Elektronikvorrichtung bauteilreduziert ausbildbar.

Dadurch, dass in der Gehäuseeinrichtung eine Mehrzahl an Leitereinheiten anordenbar sind, die ein gemeinsames Elektronikmodul bilden, sind die vormals mehreren Elektronikvorrichtungen in einer gemeinsamen Elektronikvorrichtung, insbesondere in einer gemeinsamen Gehäuseeinrichtung anordenbar. Hierdurch ist der vorzuhaltende Platzbedarf in der Rückblickvorrichtung reduziert.

Weitere Merkmale, Einzelheiten sowie Vorteile der Erfindung entnehmen sich aus den beigefügten Patentansprüchen, aus der zeichnerischen Darstellung und nachfolgender Beschreibung einer Ausführungsform der Elektronikvorrichtung.

In der Zeichnung zeigt:
- Fig. 1: eine geschnittene Seitenansicht auf ein Ausführungsbeispiel der Elektronikvorrichtung;
- Fig. 2: eine Seitenansicht auf ein Deckelteil mit erstem Haltemittel und Elektronikmodul gemäß Figur 1 gemäß Ausführungsbeispiel nach Figur 1;
- Fig. 3: eine Unteransicht auf dem Gegenstand gemäß Figur 2.

Die Figuren zeigen eine insgesamt mit dem Bezugszeichen 2 versehene Elektronikvorrichtung für eine Rückblickvorrichtung (in den Figuren nicht dargestellt) für ein Kraftfahrzeug. Die Elektronikvorrichtung 2 umfasst eine Gehäuseeinrichtung 4, die ein Bodenteil 6 und ein am Bodenteil 6 angeordnetes Deckelteil 8 umfasst. Das Bodenteil 6 und das Deckelteil 8 begrenzen einen Hohlraum 10.

Bei dem in den Figuren gezeigten Ausführungsbeispiel ist am Deckelteil 8 ein erstes Haltemittel 12 eine Halteeinheit 14 festgelegt. Das in den Figuren gezeigte Ausführungsbeispiel umfasst drei erste Haltemittel 12 die in korrespondierend ausgebildeten zweiten Haltemitteln 16, die an einer Halteplatte 18 der Rückblickvorrichtung angeordnet sind eingreifen, um einen Hintergriff zu bilden.

Darüber hinaus umfasst die Elektronikvorrichtung 2 ein Elektronikmodul 20, das eine Leitereinheit 22 und ein Kontaktmittel 24 umfasst. Die mindestens eine Leitereinheit 22 ist auf einer den Hohlraum 10 zugewandten Oberfläche des Deckelteils 8 angeordnet. Die eine Leitereinheit 22 umfasst einen Träger 26 und unmittelbar auf den Träger 26 aufgebrachte Leiterbahnen 28. Der Träger 26 ist durch eine Funktionsfläche 30 des Deckelteils 8 gebildet. Die Funktionsfläche 30 ist ein Element des Deckelteils 8 bei der die Leiterbahnen 28 beispielsweise mittels Spritzguss, durch eine leitende Folie oder durch Laserdirektstrukturierung aufgebracht wurden.

Das Kontaktmittel 24 ist einerseits mit der Leitereinheit 22 verbunden und durch das Deckelteil 8 derart erstreckt, dass es mit einem Kontaktabschnitt 32 von außen zugänglich ist.

Bei dem in den Figuren gezeigten Ausführungsbeispiel umfasst das Elektronikmodul 20 eine Mehrzahl an Leitereinheiten 22, die eine gemeinsame Steuereinheit 33 für eine Mehrzahl an elektrischen Verbrauchern der Rückblickvorrichtung bilden. Hierbei dient der Kontaktabschnitt 32 zum Einen dazu, die einzelnen elektrischen Verbraucher mit dem gemeinsamen Elektronikmodul 20 zu verbinden und zum Anderen eine Verbindung zu einer Stromquelle, wie beispielsweise im Kraftfahrzeug angeordnet ist, herzustellen.

Bei dem in den Figuren gezeigten Ausführungsbeispiel umfassen sowohl das Deckelteil 8 als auch das Bodenteil 6 einen zylindrischen Abschnitt, mit dem sie beim Fügen konzentrisch und teleskopartig ineinander schiebbar sind. Das Deckelteil 8 weist hierbei einen radial zum zylindrischen Abschnitt hervorstehenden und um die Außenfläche des Deckelteils 8 vollständig umlaufenden Randabschnitt 34 auf. Dieser bildet beim Fügen des Deckelteils 8 einen Endanschlag 36 für das Bodenteil 6. Um die Gefahr eines Eindringens von Schmutz und Feuchtigkeit in den Hohlraum 10 der Gehäuseeinrichtung 4 zu reduzieren, ist zwischen Deckelteil 8 und Bodenteil 6, insbesondere zwischen dem Randabschnitt 34 des Deckelteils 8 und dem Bodenteil 6 ein Dichtmittel 38 vorgesehen.

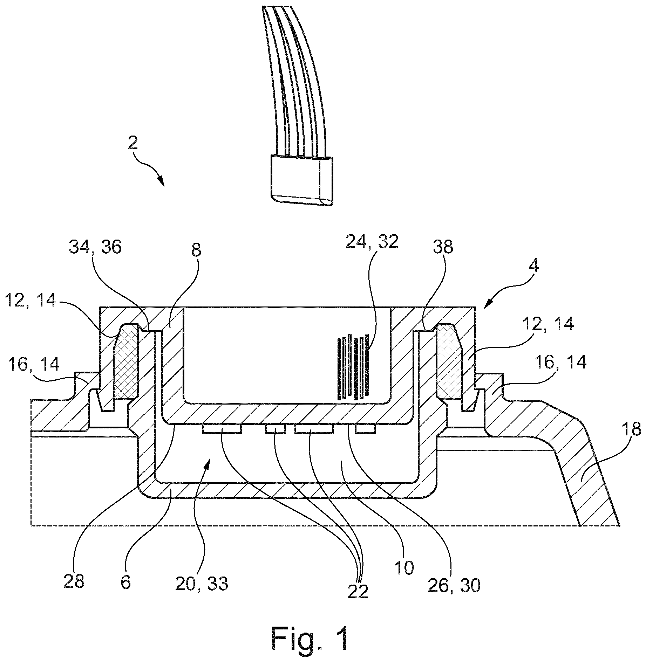

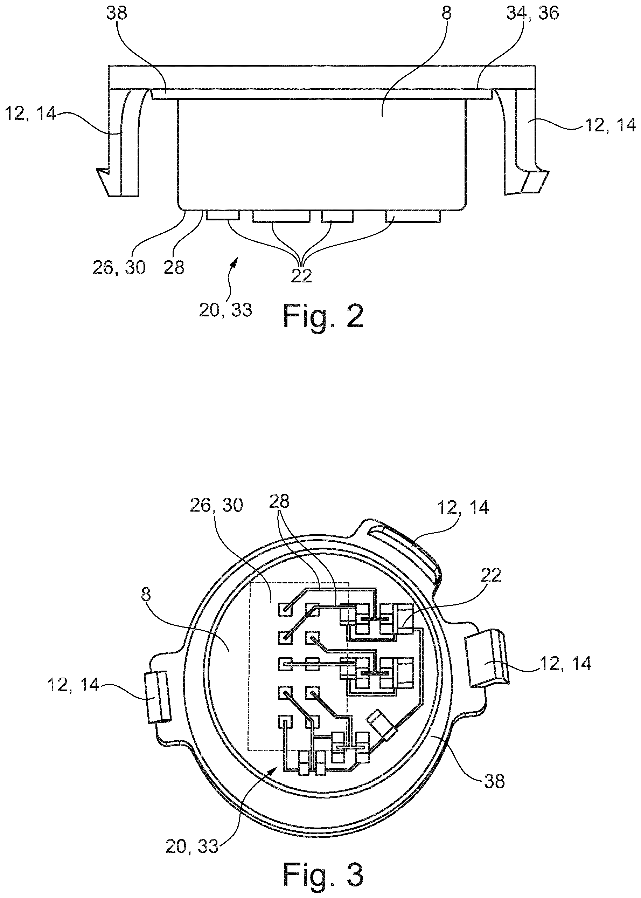

Die Figuren 2 und 3 zeigen eine Seitenansicht bzw. eine Unteransicht auf das in Figur 1 dargestellte Deckelteil 8. Das erste Haltemittel 12 der Halteeinheit 14 sowie das Deckelteil 8 umfassen ein gemeinsames Bauteil.

Im Folgenden wird die Montage bzw. Demontage der Elektronikvorrichtung 2 skizziert:

In eine Halteplatte 18 der Rückblickvorrichtung sind das Bodenteil 6 und die zweiten Haltemittel 16 der Halteeinheit 14 festgelegt. Bei dem in Figur 1 gezeigten Ausführungsbeispiel umfassen Halteplatte 18, zweite Haltemittel 16 der Halteeinheit 14 und Bodenteil 6 ein gemeinsames Bauteil, insbesondere ein gemeinsames Spritzgussbauteil.

An dem Deckelteil 8 sind die ersten Haltemittel 12 der Halteeinheit 14 festgelegt und umfassen bei dem in den Figuren 1 bis 3 gezeigten Ausführungsbeispiel ein gemeinsames Bauteil mit dem Deckelteil 8, insbesondere ein gemeinsames Spritzgussbauteil. Darüber hinaus sind an dem Deckelteil 8 das Dichtmittel 38 sowie das Elektronikmodul mit seinen Komponenten Leitereinheit 22, Träger 26, der durch die Funktionsfläche 30 am Deckelteil 8 gebildet ist und die auf die Funktionsfläche 30 angeordnete Leiterbahnen 28 und das Kontaktmittel 24 festgelegt. Das Deckelteil 8 wird zum Montieren mit einem zylindrischen Abschnitt axial in das Bodenteil 6 eingeführt. Beim Erreichen der gefügten Endstellung wird ein weiteres Bewegen des Deckelteils 8 in Richtung auf das Bodenteil 6 durch den Randabschnitt 34 des Deckelteils 8, der den Endanschlag 36 bildet und der durch das im Randabschnitt 34 angeordnete Dichtmittel 36 begrenzt. In dieser Anordnung verrasten die erste Haltemittel 12 der Halteeinheit 14 mit den zweite Haltemitteln 16 der Halteeinheit 14. Hierdurch ist das Deckelteil 8 gegen ein Zurückbewegen festgelegt.

Zum Herstellen der Betriebsbereitschaft können nun die elektrischen Verbraucher sowie die Stromquelle über den Kontaktabschnitt 32 des Kontaktmittels 24 mit der Elektronikvorrichtung 2 verbunden werden.

Zum Demontieren der Elektronikvorrichtung 2 werden die ersten Haltemittel 12 der Halteeinheit 14 aus ihrer Verrastung gelöst, wodurch das Deckelteil 8 für eine Bewegung entgegen der Montagerichtung freigegeben ist. Das Deckelteil 8 kann nun entgegen der Montagerichtung von dem Bodenteil 6 entfernt werden.

Die in der vorstehenden Beschreibung, in den Ansprüchen, sowie in den Zeichnungen gezeigten Merkmale der Erfindung können sowohl einzeln als auch in jeder beliebigen Kombination in der Verwirklichung der Erfindung und ihren verschiedenen Ausführungsformen wesentlich sein.

### Bezugszeichenliste

- 2: Elektronikvorrichtung
- 4: Gehäuseeinrichtung
- 6: Bodenteil
- 8: Deckelteil
- 10: Hohlraum
- 12: erstes Haltemittel
- 14: Halteinheit
- 16: zweites Haltemittel
- 18: Halteplatte
- 20: Elektronikmodul
- 22: Leitereinheit
- 24: Kontaktmittel
- 26: Träger
- 28: Leiterbahn
- 30: Funktionsfläche
- 32: Kontaktabschnitt
- 33: Steuereinheit
- 34: Randabschnitt
- 36: Endanschlag
- 38: Dichtmittel

## Patentansprüche

1. Elektronikvorrichtung (2), die für die Verwendung in einer Rückblickvorrichtung eines Kraftfahrzeuges eingerichtet ist,
mit mindestens einer Gehäuseeinrichtung (4), die mindestens ein Bodenteil (6) und ein am Bodenteil (6) anordbares oder angeordnetes Deckelteil (8) umfasst, welche im gefügten Zustand einen zumindest nahezu in Gänze geschlossenen Hohlraum (10) begrenzen,
mit mindestens einem ersten Haltemittel (12) einer Halteeinheit (14), durch die die Gehäuseeinrichtung (4) in oder an der Rückblickvorrichtung festlegbar oder festgelegt ist, und
mit mindestens einem Elektronikmodul (20), das mindestens eine Leitereinheit (22) und mindestens ein mit der Leitereinheit (22) verbundenes Kontaktmittel (24) umfasst, wobei
auf einer dem Hohlraum (10) zugewandten Oberfläche des Bodenteils (6) und/oder Deckelteils (8) die Leitereinheit (22) angeordnet ist, welche mindestens einen Träger (26) und mindestens eine unmittelbar auf dem Träger (26) aufgebrachte Leiterbahn (28) umfasst,
das sich durch das Deckelteil (8) und/oder durch das Bodenteil (6) erstreckende Kontaktmittel (24) mit mindestens einem hervorstehenden Kontaktabschnitt (32) von außen zugänglich ist,
durch eine an den Hohlraum (10) angrenzende und dem Hohlraum (10) zugewandte Funktionsfläche (30) des Bodenteils (6) und/oder des Deckelteils (8) der mindestens eine Träger (26) der mindestens einen Leitereinheit (22) zumindest abschnittweise gebildet ist, und
das Deckelteil (8) und/oder Bodenteil (6) mit dem mindestens einem erstes Haltemittel (12) der Halteeinheit (14) in einem gemeinsamen Bauteil ausgebildet ist bzw. sind.

2. Elektronikvorrichtung nach Anspruch 1, **dadurch gekennzeichnet, dass** der mindestens eine Träger (26) in Gänze durch die Funktionsfläche (30) des Bodenteils (6) und/oder Deckteilteils (8) gebildet ist.

3. Elektronikvorrichtung (2) nach Anspruch 1 oder 2, **dadurch gekennzeichnet, dass**
die unmittelbar auf dem Träger (26), insbesondere der Funktionsfläche (30), aufgebrachte Leiterbahn (28) mittels Spritzguss (Molded Interconnect Devices [MID]), durch eine leitende Folie (Inmold-Labeling [IML]) und/oder durch Laser-Direkt-Strukturierung [LDS] unmittelbar an den Träger (26), insbesondere die Funktionsfläche (30), aufgebracht ist.

4. Elektronikvorrichtung (2) nach mindestens einem der vorhergehenden Ansprüche,
**dadurch gekennzeichnet, dass**
das Elektronikmodul (20) eine Mehrzahl an Leitereinheiten (22) umfasst, und/oder
das Elektronikmodul (20) eine gemeinsame Steuereinheit (33) für eine Mehrzahl an elektrischen Verbrauchern der Rückblickvorrichtung bildet,
wobei jedem elektrischen Verbraucher mindestens eine Leitereinheit (22) funktional zuordenbar oder zugeordnet ist, und
wobei insbesondere mindestens eine Hauptleitereinheit eine Treiberschaltung umfasst, durch die die den elektrischen Verbrauchern funktional zugeordneten Leitereinheiten (22) einzeln und/oder gemeinsam ansteuerbar sind.

5. Elektronikvorrichtung (2) nach mindestens einem der vorhergehenden Ansprüche,
**dadurch gekennzeichnet, dass**
das gemeinsame Bauteil des mindestens einen ersten Haltemittels (12) und des Deckelteils (8) und/oder Bodenteils ein Spritzgussteil ist, und/oder
das Deckelteil (8) mit dem mindestens einem ersten Haltemittel (12) der Halteeinheit (14) in einem gemeinsames Bauteil ausgebildet ist.

6. Elektronikvorrichtung (2) nach mindestens einem der vorhergehenden Ansprüche,
**dadurch gekennzeichnet, dass**
die Gehäuseeinrichtung (4) durch das erste Haltemittel (12) lösbar, insbesondere mittels Hintergriff, in oder an der Rückblickvorrichtung festlegbar oder festgelegt ist, und/oder
das erste Haltemittel (12) einen Außengewindeabschnitt am Deckelteil (8) oder am Bodenteil (6), ein Rastelement, wie Clips oder Bajonettverschluss, und/oder eine Schraub- oder Bolzenelement umfasst.

7. Elektronikvorrichtung (2)nach Anspruch 6, **dadurch gekennzeichnet, dass**
das erste Haltemittel (12) mit einem ersten Ende an einem der Funktionsfläche des Deckelteils (8) oder des Bodenteils (6) entgegengesetzten Ende des Deckelteils (8) bzw. des Bodenteils (6) festgelegt und mit einem zweiten Ende in Richtung Funktionsfläche (30) erstreckt angeordnet ist,
wobei das erste Haltemittel (12) überlappungsfrei zur Ebene der Funktionsfläche erstreckt ausgebildet ist und das zweite Ende zur Ebene der Funktionsfläche einen Abstand aufweist.

8. Elektronikvorrichtung (2) nach Anspruch 6 oder 7, **dadurch gekennzeichnet, dass**
die Halteeinheit (14) ein in oder an der Rückblickvorrichtung, insbesondere an einer Halteplatte (18) der Rückblickvorrichtung, festgelegtes, zweites Haltemittel (16) umfasst, wobei
vorzugsweise das zweite Haltemittel (16) einen Innengewindeabschnitt, der mit dem als Außengewindeabschnitt ausgebildeten ersten Haltemittel (12) zusammenwirkbar ist, ein mit dem als Rastelement ausgebildeten ersten Haltemittel (12) hintergreifend zusammenwirkendes Aufnahmemittel und/oder eine Aufnahme für das als Schraub- oder Bolzenelement ausgebildete erste Haltemittel (12) umfasst.

9. Elektronikvorrichtung (2) nach mindestens einem der vorhergehenden Ansprüche,
**dadurch gekennzeichnet, dass**
der mindestens eine hervorstehende und von außen zugängliche Kontaktabschnitt (32) des mindestens einen Kontaktmittels (24) mindestens einen Pin, insbesondere eine Mehrzahl an Pins, umfasst, durch die das Elektronikmodul (20) mit mindestens einer Stromquelle und/oder mit mindestens einem elektrischen Verbraucher verbindbar oder verbunden ist und/oder,
die Elektronikvorrichtung (2) mindestens einen im Hohlraum (10) der Gehäuseeinrichtung (4) angeordneten und dem Elektronikmodul (20) funktional zugeordneten Energiespeicher, zum insbesondere Speichern und Freisetzen von elektrischer Energie, umfasst.

10. Elektronikvorrichtung (2) nach mindestens einem der vorhergehenden Ansprüche,
**dadurch gekennzeichnet, dass**
das Deckelteil (8) und das Bodenteil (6) jeweils einen zylindrischen Abschnitt umfassen, mit dem sie beim Fügen, insbesondere konzentrisch, teleskopartig ineinander schiebbar sind,
wobei das Deckelteil (8) einen radial zum zylindrischen Abschnitt hervorstehenden und um die Außenfläche des Deckteils (8) vollständig umlaufenden Randabschnitt (34) umfasst, der beim Fügen des Deckelteils (8) und des Bodenteils (6) einen Endanschlag (36) bildet.

11. Elektronikvorrichtung (2) nach Anspruch 9, **dadurch gekennzeichnet, dass**
das Deckelteil (8) und/oder das Bodenteil (6) topfartig aus ausgebildet ist/sind,
wobei zumindest das Deckelteil (8) eine an den zylindrischen Abschnitt angrenzende flächenhafte Bodenplatte umfasst, die quer oder schräg zur Achse des zylindrischen Abschnitts verläuft und an deren dem Bodenteil (6) zugewandten Seite die Funktionsfläche (30) angeordnet ist sowie an deren dem Bodenteil (6) abgewandten und durch den zylindrischen Abschnitt umgebenen Seite der Kontaktabschnitt (32) des Kontaktmittels (24) angeordnet ist.

12. Elektronikvorrichtung (2) nach mindestens einem der vorhergehenden Ansprüche,
**gekennzeichnet durch**
mindestens ein zwischen dem Deckelteil (8) und dem Bodenteil (6), insbesondere zwischen dem Bodenteil (6) und dem Randabschnitt (34) des Deckelteils (8), angeordnetes Dichtmittel (38), durch das der Hohlraum (10) der Gehäuseeinrichtung (4) gegenüber einem zwischen Deckelteil (8) und des Bodenteil (6) bestehenden Spalts abdichtbar ist.

13. Elektronikvorrichtung (2) nach mindestens einem der vorhergehenden Ansprüche,
**dadurch gekennzeichnet, dass**
das Bodenteil (6) der Gehäuseeinrichtung (4) ein Element eines Bauteils, insbesondere eines einstückigen Spritzgussteils, wie der Halteplatte (18) und/oder des zweiten Haltemittels (16), der Rückblickvorrichtung umfasst.

14. Elektronikvorrichtung (2) nach mindestens einem der vorhergehenden Ansprüche,
**dadurch gekennzeichnet, dass**
das Bodenteil (6), das Deckelteil (8), das erste Haltemittel (12) und/oder das zweite Haltemittel (16) einen Kunststoff umfassen.

15. Rückblickvorrichtung für ein Kraftfahrzeug mit mindestens einer Elektronikvorrichtung (2) nach einem der Ansprüche 1 bis 14.

16. Rückblickvorrichtung nach Anspruch 15, **dadurch gekennzeichnet, dass**
das Bodenteil (6) der Gehäuseeinrichtung (4) mit dem zweiten Haltemittel (16) und der Halteplatte (18) der Rückblickvorrichtung ausgebildet ist, und
das Deckelteil (8) der Gehäuseeinrichtung (4) mit dem ersten Haltemittel (12) ausgebildet ist.

## Claims

1. An electronic device (2) which is designed for use in a rearview device of a vehicle, having at least one housing device (4) which comprises at least one floor piece (6) and a cover piece (8) arranged or arrangeable on the floor piece (6), which, in the joined state, delimit an at least almost completely closed cavity (10),
having at least one first retaining means (12) of a retaining unit (14), through which the housing device (4) is fixed or fixable in or on the rearview device, and
having at least one electronic module (20) which comprises at least one conductor unit (22) and at least one contact means (24) connected to the conductor unit (22), wherein
the conductor unit (22) is arranged on a surface of the floor piece (6) and/or cover piece (8) turned towards the cavity (10), which comprises at least one carrier (26) and at least one conductor path (28) applied directly to the carrier (26),
the contact means (24) extending through the cover piece (8) and/or through the floor piece (6) with at least one protruding contact section (32) is accessible externally,
the at least one carrier (26) of the at least one conductor unit (22) is formed at least in sections by a functional surface (30) of the floor piece (6) and/or the cover piece (8) adjacent to the cavity (10) and turned towards the cavity (10), and
the cover piece (8) and/or floor piece (6) with the at least one first retaining means (12) of the retaining unit (14) is or respectively are configured as a common component.

2. The electronic device according to claim 1, **characterized in that** the at least one carrier (26) is formed entirely by the functional surface (30) of the floor piece (6) and/or cover piece (8).

3. The electronic device (2) according to claim 1 or 2, **characterized in that** the conductor path (28) applied directly to the carrier (26), in particular the functional surface (30), is applied by injection molding (Molded Interconnect Devices [MID]), by a conductive foil (Inmold-Labeling [IML]) and/or by Laser Direct Structuring [LDS] directly to the carrier (26), in particular the functional surface (30).

4. The electronic device (2) according to at least one of the preceding claims,
**characterized in that**
the electronic module (20) comprises a plurality of conductor units (22), and/or
the electronic module (20) forms a common control unit (33) for a plurality of electrical appliances of the rearview device,
wherein at least one conductor unit (22) is functionally assigned or assignable to each electrical appliances, and
wherein in particular at least one main conductor unit comprises a driver circuit, via which the conductor units (22) functionally assigned to the electrical loads are individually and/or jointly controllable.

5. The electronic device (2) according to at least one of the preceding claims,
**characterized in that**
the common component of the at least one first retaining means (12) and of the cover piece (8) and/or of the floor piece is an injection molded part, and/or
the cover piece (8) with the at least one first retaining means (12) of the retaining unit (14) is configured as a common component.

6. The electronic device (2) according to at least one of the preceding claims,
**characterized in that**
the housing device (4) is fixed or fixable by the first retaining means (12), detachably, in particular by means of a rear grip, in or on the rearview device, and/or
the first retaining means (12) comprises an externally threaded section on the cover piece (8) or on the floor piece (6), a latching element, such as clips or a bayonet fitting, and/or a screw or bolt element.

7. The electronic device (2) according to claim 6, **characterized in that**
the first retaining means (12) is fixed with a first end to an end of the cover piece (8) or the floor piece (6) opposite the functional surface of the cover piece (8) or floor piece (6) and is arranged with a second end extending in the direction of the functional surface (30),
wherein the first retaining means (12) is configured to extend without overlapping to the plane of the functional surface and the second end has a distance from the plane of the functional surface.

8. The electronic device (2) according to claim 6 or 7, **characterized in that**
the retaining unit (14) comprises a second retaining means (16) fixed in or on the rearview device, in particular on a retaining plate (18) of the rearview device, wherein
preferably the second retaining means (16) comprises an internally threaded section which is able to interact with the first retaining means (12) configured as an externally threaded section, a rear-gripping receiving means interacting with the first retaining means (12) configured as a latching element and/or a receptacle for the first retaining means (12) configured as a screw or bolt element.

9. The electronic device (2) according to at least one of the preceding claims,
**characterized in that**
the at least one protruding and externally accessible contact section (32) of the at least one contact means (24) comprises at least one pin, in particular a plurality of pins, via which the electronic module (20) is connected or connectable to at least one power source and/or to at least one electrical appliance, and/or
the electronic device (2) comprises at least one energy storage arranged in the cavity (10) of the housing device (4) functionally assigned to the electronic module (20), in particular for storing and releasing electrical energy.

10. The electronic device (2) according to at least one of the preceding claims,
**characterized in that**
the cover piece (8) and the floor piece (6) in each case comprise a cylindrical section, with which, when they are being joined, they are slidable into each other, in particular concentrically, telescopically,
wherein the cover piece (8) comprises an edge section (34) protruding radially with regard to the cylindrical section and extending fully around the outer surface of the cover piece (8), which when the cover piece (8) and the floor piece (6) are joined forms an end stop (36).

11. The electronic device (2) according to Claim 9, **characterized in that**
the cover piece (8) and/or the floor piece (6) has/have a pot-like configuration,
wherein at least the cover piece (8) comprises an extensive base plate adjacent to the cylindrical section, which runs transversally or inclined to the axis of the cylindrical section, and on its side turned towards the floor piece (6) the functional surface (30) is arranged and on its side turned away from the floor piece (6) and surrounded by the cylindrical section the contact section (32) of the contact means (24) is arranged.

12. The electronic device (2) according to at least one of the preceding claims,
**characterized by**
at least one sealant (38) arranged between the cover piece (8) and the floor piece (6), in particular between the floor piece (6) and the edge section (34) of the cover piece (8), by means of which the cavity (10) of the housing device (4) is sealable with respect to a gap existing between the cover piece (8) and the floor piece (6).

13. The electronic device (2) according to at least one of the preceding claims,
**characterized in that**
the floor piece (6) of the housing device (4) comprises an element of a component, in particular a one-piece injection molded part, such as the retaining plate (18) and/or the second retaining means (16), of the rearview device.

14. The electronic device (2) according to at least one of the preceding claims,
**characterized in that**
the floor piece (6), the cover piece (8), the first retaining means (12) and/or the second retaining means (16) comprise a plastic.

15. A rearview device for a motor vehicle having at least one electronic device (2) according to any one of Claims 1 to 14.

16. The rearview device according to Claim 15, **characterized in that**
the floor piece (6) of the housing device (4) is configured with the second retaining means (16) and the retaining plate (18) of the rearview device, and
the cover piece (8) of the housing device (4) is configured with the first retaining means (12).

## Revendications

1. Dispositif électronique (2), conçu pour une utilisation dans un dispositif de rétroviseur d'un véhicule automobile,
présentent au moins un dispositif de boîtier (4), qui comprend au moins une partie de fond (6) et une partie de couvercle (8) qui est ou peut être disposée sur la partie de fond (6), lesquelles délimitent à l'état assemblé une cavité (10) fermée au moins presque en totalité,
présentent au moins un premier moyen de retenue (12) d'une unité de retenue (14), grâce à laquelle le dispositif de boîtier (4) est ou peut être fixée dans ou sur le dispositif de rétroviseur, et
présentent au moins un module électronique (20) qui comprend au moins une unité conductrice (22) et au moins un moyen de contact (24) relié à l'unité conductrice (22),
dans lequel
l'unité conductrice (22) est disposée sur une surface, de la partie de fond (6) et/ou de la partie de couvercle (8), située en regard de la cavité (10), laquelle unité conductrice (22) comprend au moins un support (26) et au moins une piste conductrice (28) appliquée directement sur le support (26),
le moyen de contact (24) s'étendant à travers la partie de couvercle (8) et/ou à travers la partie de fond (6) est accessible de l'extérieur avec au moins une section de contact en saillie (32),
l'au moins un support (26) de l'au moins une unité conductrice (22) est formé au moins dans certaines sections par une surface fonctionnelle (30) de la partie de fond (6) et/ou de la partie de couvercle (8) qui est adjacente à la cavité (10) et située en regard de la cavité (10), et
la partie de couvercle (8) et/ou la partie de fond (6) est ou sont réalisée(s) avec l'au moins un premier moyen de retenue (12) de l'unité de retenue (14) pour former un composant commune.

2. Dispositif électronique selon la revendication 1, **caractérisé en ce que**
l'au moins un support (26) est formé en totalité par la surface fonctionnelle (30) de la partie de fond (6) et/ou de la partie de couvercle (8).

3. Dispositif électronique (2) selon la revendication 1 ou 2, **caractérisé en ce que**
la piste conductrice (28) appliquée directement sur le support (26), en particulier la surface fonctionnelle (30), est appliquée directement sur le support (26), en particulier la surface fonctionnelle (30), au moyen d'un moulage par injection (Molded Interconnect Devices [MID]), par l'intermédiaire d'une feuille conductrice (Inmold-Labeling [IML]) et/ou par l'intermédiaire d'une structuration directe par laser (Laser-Direkt-Strukturierung [LDS]).

4. Dispositif électronique (2) selon au moins l'une quelconque des revendications précédentes, **caractérisé en ce que**
le module électronique (20) comprend une pluralité d'unités conductrices (22), et/ou
le module électronique (20) forme une unité de commande commune (33) pour une pluralité de consommateurs électriques du dispositif de rétroviseur,
dans lequel à chaque consommateur électrique est ou peut être associée de manière fonctionnelle au moins une unité conductrice (22), et
dans lequel en particulier au moins une unité conductrice principale comprend un circuit d'excitation, grâce auquel les unités conductrices (22) associées de manière fonctionnelle aux consommateurs électriques peuvent être actionnées de manière individuelle et/ou en commun.

5. Dispositif électronique (2) selon au moins l'une quelconque des revendications précédentes, **caractérisé en ce que**
le composant commune de l'au moins un premier moyen de retenue (12) et de la partie de couvercle (8) et/ou de la partie de fond est une pièce moulée par injection, et/ou
la partie de couvercle (8) est réalisée avec l'au moins un premier moyen de retenue (12) de l'unité de retenue (14) pour former un composant commune.

6. Dispositif électronique (2) selon au moins l'une quelconque des revendications précédentes, **caractérisé en ce que**
le dispositif de boîtier (4) est ou peut être fixée de manière détachable dans ou sur le dispositif de rétroviseur par l'intermédiaire du premier moyen de retenue (12), en particulier au moyen d'une poignée arrière, et/ou
le premier moyen de retenue (12) comprend une section de filetage extérieur sur la partie de couvercle (8) ou sur la partie de fond (6), un élément d'encliquetage, tels des attaches (clips) ou une fermeture à baïonnette, et/ou un élément de vis ou de boulon.

7. Dispositif électronique (2) selon la revendication 6, **caractérisé en ce que**
le premier moyen de retenue (12) est fixé avec une première extrémité à une extrémité de la partie de couvercle (8) respectivement de la partie de fond (6) qui est opposée à la surface fonctionnelle de la partie de couvercle (8) ou de la partie de fond (6) et est disposé avec une seconde extrémité de manière étendue dans la direction de la surface fonctionnelle (30),
dans lequel le premier moyen de retenue (12) est réalisé de manière étendue sans chevauchement par rapport au plan de la surface fonctionnelle et la seconde extrémité présente une distance par rapport au plan de la surface fonctionnelle.

8. Dispositif électronique (2) selon la revendication 6 ou 7, **caractérisé en ce que**
l'unité de retenue (14) comprend un second moyen de retenue (16) fixé dans ou sur le dispositif de rétroviseur, en particulier sur une plaque de retenue (18) du dispositif de rétroviseur,
dans lequel
de préférence le second moyen de retenue (16) présente une section de filetage intérieur qui peut coopérer avec le premier moyen de retenue (12) réalisé sous la forme d'une section de filetage extérieur, comprend un moyen de logement coopérant avec le premier moyen de retenue (12) réalisé sous la forme d'un élément d'encliquetage en s'engageant par l'arrière et/ou un logement pour le premier moyen de retenue (12) réalisé sous la forme d'un élément de vis ou de boulon.

9. Dispositif électronique (2) selon au moins l'une quelconque des revendications précédentes, **caractérisé en ce que**
l'au moins une section de contact (32), en saillie et accessible par l'extérieur, de l'au moins un moyen de contact (24) comprend au moins une broche, en particulier une pluralité de broches, grâce auxquelles le module électronique (20) est ou peut être relié à au moins une source de courant et/ou à au moins un consommateur électrique et/ou,
le dispositif électronique (2) comprend au moins un accumulateur d'énergie disposé dans la cavité (10) du dispositif de boîtier (4) et associé en fonctionnement au module électronique (20), en particulier pour accumuler et restituer l'énergie électrique.

10. Dispositif électronique (2) selon au moins l'une quelconque des revendications précédentes, **caractérisé en ce que**
la partie de couvercle (8) et la partie de fond (6) comprennent respectivement une section cylindrique, grâce à laquelle elles peuvent, lors de l'assemblage, être poussées l'une dans l'autre de manière télescopique, en particulier de manière concentrique,
dans lequel la partie de couvercle (8) comprend une section de bord radial (34) en saillie par rapport à la section cylindrique et entièrement périphérique autour de la surface extérieure de la partie de couvercle (8), laquelle section de bord radial forme une butée d'extrémité (36) lors de l'assemblage de la partie de couvercle (8) et de la partie de fond (6).

11. Dispositif électronique (2) selon la revendication 9, **caractérisé en ce que** la partie de couvercle (8) et/ou la partie de fond (6) est/sont réalisée(s) en forme de pot,
dans lequel au moins la partie de couvercle (8) comprend une plaque de fond s'étendant de manière adjacente à la section cylindrique, qui s'étend transversalement ou de manière oblique par rapport à l'axe de la section cylindrique et, sur sa face située en regard de la partie de fond (6), est disposée la surface fonctionnelle (30) tandis que, sur sa face opposée à la partie de fond (6) et entourée par la section cylindrique est disposée la section de contact (32) du moyen de contact (24).

12. Dispositif électronique (2) selon au moins l'une quelconque des revendications précédentes, **caractérisé par**
au moins un moyen d'étanchéité (38), disposé entre la partie de couvercle (8) et la partie de fond (6), en particulier entre la partie de fond (6) et la section de bord (34) de la partie de couvercle (8), grâce auquel la cavité (10) du dispositif de boîtier (4) peut être rendue étanche vis-à-vis d'un espace existant entre la partie de couvercle (8) et la partie de fond (6).

13. Dispositif électronique (2) selon au moins l'une quelconque des revendications précédentes, **caractérisé en ce que**
la partie de fond (6) du dispositif de boîtier (4) comprend un élément de la composante, en particulier d'une pièce moulée par injection formée d'un seul tenant, telle que la plaque de retenue (18) et/ou du second moyen de retenue (16), du dispositif de rétroviseur.

14. Dispositif électronique (2) selon au moins l'une quelconque des revendications précédentes, **caractérisé en ce que**
la partie de fond (6), la partie de couvercle (8), le premier moyen de retenue (12) et/ou le second moyen de retenue (16) comprennent une matière plastique.

15. Dispositif de rétroviseur pour un véhicule automobile comprenant au moins un dispositif électronique (2) selon l'une quelconque des revendications 1 à 14.

16. Dispositif de rétroviseur selon la revendication 15, **caractérisé en ce que**
la partie de fond (6) du dispositif de boîtier (4) est réalisée avec le second moyen de retenue (16) et la plaque de retenue (18) du dispositif de rétroviseur, et
la partie de couvercle (8) du dispositif de boîtier (4) est réalisée avec le premier moyen de retenue (12).
